# EUROPÄISCHE PATENTANMELDUNG

(11) **EP 1 443 812 A2**
(43) Veröffentlichungstag der Anmeldung: **04.08.2004**
(21) Anmeldenummer: 03104599.0
(22) Anmeldetag: 09.12.2003
(51) Int. Cl.: H05K 7/14

(54) **Leiterplattenanordnung**

(30) Priorität: 31.01.2003 DE 10303956
(71) Anmelder: SIEMENS AKTIENGESELLSCHAFT, 80333 München (DE)
(72) Erfinder: Seifert, Roland, 69115, Heidelberg (DE); Klein, Martin, 35638, Leun (DE)

(57) **Zusammenfassung**

Es wird eine Leiterplattenanordnung mit einer ersten und einer zweiten Leiterplatte (1, 2) vorgeschlagen, die über ein Verbindungselement (3) mechanisch fest miteinander verbunden sind, wobei das Verbindungselement (3) einen Codierpin (7) enthält, der in eine Aussparung (6) der zweiten Leiterplatte (2) hineinragt.

## Beschreibung

Die Erfindung betrifft eine Leiterplattenanordnung mit einer ersten und einer zweiten Leiterplatte.

In Navigationsgeräten für Kraftfahrzeuge werden Leiterplattenanordnungen eingesetzt, bei denen eine Grundplatte und mindestens eine weitere Leiterplatte miteinander verkoppelt sind. Die Leiterplatten sind hierbei parallel zueinander angeordnet. Über elektrische Verbindungselemente erfolgt die elektrische Verbindung zwischen den beiden Leiterplatten. Die mechanisch feste Verbindung zwischen den beiden Leiterplatten kann durch Abstandsbolzen erreicht werden, die mit je einer Schraube an der Grundplatte und an der weiteren Leiterplatte befestigt sind.

Bei den oben erwähnten Navigationsgeräten kann die weitere Leiterplatte insbesondere eine PCI-Bus-Steckkarte nach PMC-Standard sein. Diese PCI-Bus-Steckkarten sind als 3,3 Volt und 5 Volt-Versionen erhältlich. Um nun festzulegen, welcher Steckkartentyp mit der speziellen Grundplatte gekoppelt werden darf, ist ein mechanisches Codiersystem vorhanden. Die Steckkarte enthält eine Aussparung, die bei beiden Kartentypen an unterschiedlicher Stelle der Leiterplatte angeordnet ist. Auf der Grundplatte wird ein Codierpin angeordnet, der in diese Aussparung hineinragt. Nur dann, wenn der Codierpin durch die Aussparung der zweiten Leiterplatte ragt, kann diese fest mit der Grundplatte verschraubt werden. Durch die Positionierung des Codierpins auf der Grundplatte wird somit festgelegt, welcher Steckkartentyp mit dieser speziellen Grundplatte versehen werden kann. Nachteilig ist bei dieser Ausgestaltung jedoch, dass eine gewisse Anzahl von Einzelteilen arbeitsaufwendig sowohl mit der Grundplatte als auch mit der weiteren Leiterplatte verbunden werden muss.

Aufgabe der Erfindung ist es daher, eine Leiterplattenanordnung anzugeben, die ebenfalls eine derartige Codierung aufweist, jedoch einfacher montierbar ist.
Erfindungsgemäß wird die Aufgabe gelöst durch eine Leiterplattenanordnung mit einer ersten und einer zweiten Leiterplatte, die über ein Verbindungselement mechanisch fest miteinander verbunden sind, wobei das Verbindungselement einen Codierpin enthält, der in eine Aussparung der zweiten Leiterplatte hineinragt. Durch das erfindungsgemäße Verbindungselement wird nunmehr sowohl die mechanisch feste Verbindung der beiden Leiterplatten miteinander als auch die Codierfunktion mit einem einzigen Element erreicht. Hierdurch ergibt sich eine reduzierte Bauteilezahl und damit neben einer vereinfachten Lagerhaltung auch eine deutlich vereinfachte Montage.

Vorzugsweise weist das Verbindungselement mindestens zwei Abstandsbolzen auf, die über einen Verbindungssteg miteinander verbunden sind, und auf oder an dem Verbindungssteg ist der Codierpin angeordnet. Ein derartiges Verbindungselement ist konstruktiv einfach aufgebaut und einfach herstellbar. Durch zwei Varianten mit unterschiedlicher Anordnung des Codierpins können die Verbindungselemente auf einfache Weise für zwei unterschiedliche Leiterplattentypen ausgelegt werden.

In einer besonderen Ausführungsform ist das Verbindungselement mittels einer Rastverbindung mit der ersten Leiterplatte verbunden und die zweite Leiterplatte ist mit dem Verbindungselement verschraubt. Hierdurch ist eine Montage und Demontage des Verbindungselementes in einer Arbeitsrichtung möglich, ohne dass die erste Leiterplatte umgedreht werden muss, um das Verbindungselement mit dieser zu verbinden. Das Verbindungselement wird hierbei auf die erste Leiterplatte geklippst. Anschließend wird die zweite Leiterplatte in elektrische Verbindungselemente gesteckt und mit entsprechenden Schrauben fest mit dem Verbindungselement verbunden. Die eingedrehten Schrauben verhindern ein Lösen des Befestigungselements von der Steckkarte.

Insbesondere kann die zweite Leiterplatte eine PCI-Bus-Steckkarte sein, wobei durch die Anordnung der Aussparung, in die der Codierpin hineinragt, eine Spezifizierung der zulässigen Betriebsspannung der zweiten Leiterplatte erfolgt. Durch die Anordnung des Codierpins wird somit festgelegt, ob eine PCI-Bus-Steckkarte mit einer Betriebsspannung von 3,3 Volt oder 5 Volt mit der Grundplatte verbindbar ist.

Vorteilhafter Weise wird das Verbindungselement als Kunststoffteil hergestellt. Hierdurch ist eine kostengünstige Fertigung beispielsweise als Spritzgießteil möglich. Andererseits werden durch das Kunststoffmaterial mögliche Kurzschlüsse auf den Leiterplatten durch das Verbindungselement ausgeschlossen.

Die Erfindung wird nachfolgend anhand eines Ausführungsbeispiels und der Zeichnung näher erläutert. Es zeigen:
- Figur 1: eine Leiterplattenanordnung in Explosionsdarstellung,
- Figur 2: zwei Ausgestaltungen der Verbindungselemente.

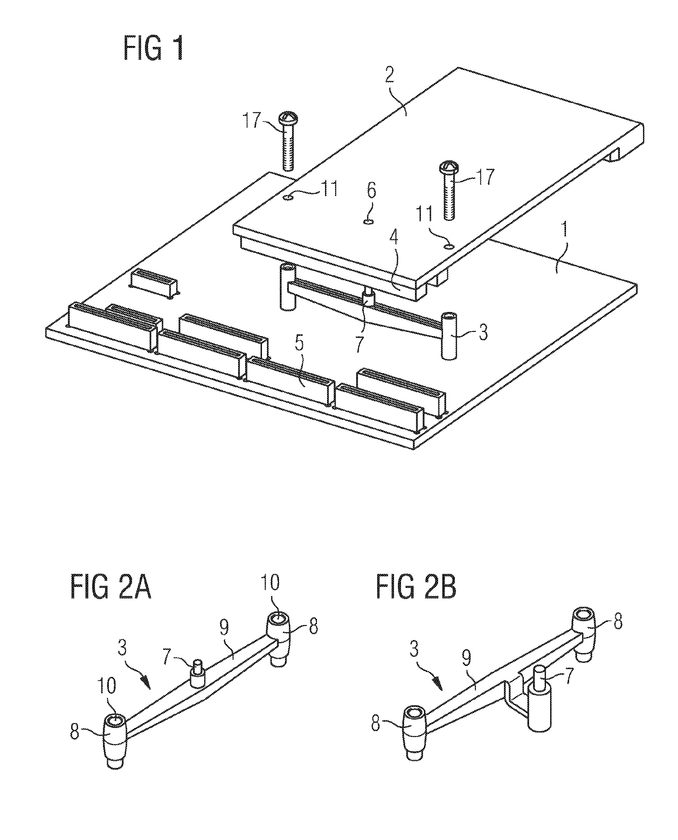

Figur 1 zeigt eine Leiterplattenanordnung in einem noch nicht fertig montierten Zustand. Eine erste Leiterplatte 1 wird mit einer zweiten Leiterplatte 2 mittels eines Verbindungselementes 3 mechanisch fest verbunden. Das Verbindungselement 3 wird in entsprechenden Aussparungen der Leiterplatte 1 eingeklippst. Anschließend wird die zweite Leiterplatte 2 mit ihren elektrischen Kontaktelementen 4 in die elektrischen Kontaktelemente 5 der ersten Leiterplatte 1 eingesteckt. Die zweite Leiterplatte 2 weist eine Aussparung 6 auf, in die ein Codierpin 7 des Verbindungselements 3 hineinragt. Die zweite Leiterplatte 2 wird anschließend mittels Schrauben 17 mit dem Verbindungselement 3 verschraubt. Somit wird eine mechanisch feste Verbindung zwischen der ersten Leiterplatte 1 und der zweiten Leiterplatte 2 erzielt. Durch den Codierpin 7 des Verbindungselements 3 wird sichergestellt, dass nur eine solche zweite Leiterplatte 2 mit dem Verbindungselement 3 und damit mit der ersten Leiterplatte 1 verbunden werden kann, die an einer der Position des Codierpins 7 entsprechenden Stelle eine Aussparung 6 aufweist.

Bei der zweiten Leiterplatte 2 handelt es sich um eine PCI-Bus-Steckkarte. Diese PCI-Bus-Steckkarten sind mit einer Betriebsspannung von 3,3 Volt oder 5 Volt erhältlich. Um sicherzustellen, dass der richtige PCI-Bus-Steckkartentyp mit der ersten Leiterplatte 1 verbunden wird, weisen die PCI-Bus-Steckkarten mit einer Betriebsspannung von 3,3 Volt und 5 Volt Aussparungen für einen Codierpin auf, die an unterschiedlichen Stellen angeordnet sind. Durch Verwendung von Verbindungselementen, bei denen der Codierpin an unterschiedlichen Stellen angeordnet ist, wird somit erreicht, dass jeweils nur einer der beiden Kartentypen mit dem Verbindungselement 3 und damit mit der ersten Leiterplatte 1 verbindbar ist.

Figur 2 zeigt die unterschiedlichen Ausgestaltungen von zwei Verbindungselementen, die beispielsweise für 3,3 Volt- und 5 Volt-PCI-Steckkarten verwendet werden können. Das in Figur 2a dargestellte Verbindungselement weist zwei Abstandsbolzen 8 auf, die über ein Verbindungssteg 9 miteinander verbunden sind. Direkt auf den Verbindungssteg 9, in gleichem Abstand zu den beiden Abstandsbolzen 8 und auf einer Verbindungslinie zwischen den Abstandsbolzen 8 ist ein Codierpin 7 angeordnet. Die Abstandsbolzen 8 weisen jeweils eine Gewindebohrung 10 auf, in die die Schrauben 17 zur Befestigung der zweiten Leiterplatte 2 eingeführt werden. Mit dem in Figur 2 dargestellten Verbindungselement können nur solche Leiterplatten verbunden werden, die eine Aussparung zur Aufnahme des Codierpins aufweisen, die mittig zwischen den beiden Löchern 11 für die Aufnahme der Schrauben 17 angeordnet ist, wobei die Löcher 11 für die Schrauben 17 und die Aussparung 6 für den Codierpin 7 auf einer Linie angeordnet sind.

Figur 2b zeigt eine zweite Ausgestaltung des Verbindungselementes, wie es für PCI-Bus-Steckkarten mit einer Betriebsspannung von 5 Volt eingesetzt wird. Bei diesem Ausführungsbeispiel ist der Codierpin 7 versetzt von der Verbindungslinie zwischen den Abstandsbolzen 8 angeordnet und zwar so, dass die beiden Abstandsbolzen 8 und der Codierpin 7 ein gleichschenkliges Dreieck bilden. Mit einem derartigen Verbindungselement können dann nur solche Steckkarten verbunden werden, die eine entsprechende Anordnung der Aussparung für den Codierpin in Relation zu den Aussparungen für die Schrauben aufweisen.

Die Leiterplattenanordnung kann in vielfältiger Weise Verwendung finden, ist durch ihre kompakte Bauform jedoch insbesondere für Kraftfahrzeugkomponenten und dort insbesondere für Kraftfahrzeugnavigationssysteme geeignet.

## Patentansprüche

1. Leiterplattenanordnung mit einer ersten und einer zweiten Leiterplatte (1, 2), die über ein Verbindungselement (3) mechanisch fest miteinander verbunden sind, wobei das Verbindungselement (3) einen Codierpin (7) enthält, der in eine Aussparung (6) der zweiten Leiterplatte (2) hineinragt.

2. Anordnung nach Anspruch 1, **dadurch**
**gekennzeichnet, dass** das Verbindungselement (3) mindestens zwei Abstandbolzen (8) aufweist, die über einen Verbindungssteg (9) miteinander verbunden sind, und auf oder an dem Verbindungssteg (9) der Codierpin (7) angeordnet ist.

3. Anordnung nach einem der vorhergehenden Ansprüche,
**dadurch gekennzeichnet, dass** das Verbindungselement (3) mittels einer Rastverbindung mit der ersten Leiterplatte (1) verbunden ist und die zweite Leiterplatte (2) mit dem Verbindungselement (3) verschraubt ist.

4. Anordnung nach einem der vorhergehenden Ansprüche,
**dadurch gekennzeichnet, dass** die zweite Leiterplatte (2) eine PCI-Bus-Steckkarte ist und durch die Anordnung der Aussparung (6), in die der Codierpin (7) hineinragt, eine Spezifizierung der zulässigen Betriebsspannung der zweiten Leiterplatte (2) erfolgt.

5. Anordnung nach Anspruch 4, **dadurch**
**gekennzeichnet, dass** durch die Anordnung des Codierpins (7) und der Aussparung (6) in der zweiten Leiterplatte (2) eine Unterscheidung zwischen PCI-Bus-Steckkarten mit einer Betriebsspannung von 3,3 Volt und 5 Volt erfolgt.

6. Anordnung nach einem der vorhergehenden Ansprüche,
**dadurch gekennzeichnet, dass** das Verbindungselement (3) ein Kunststoffteil ist.

7. Anordnung nach einem der vorhergehenden Ansprüche,
**gekennzeichnet durch** die Verwendung in einem Kraftfahrzeug-Navigationssystem.
